# EUROPEAN PATENT SPECIFICATION

(11) **EP 4 506 988 B1**
(45) Date of publication and mention of the grant of the patent: **15.07.2026**
(21) Application number: 23866601.0
(22) Date of filing: 26.09.2023
(51) Int. Cl.: H10P 50/00, H10W 20/00, H10P 76/40, H10W 70/685, H10W 70/65, H10W 70/05, H10W 99/00, H10W 70/60, H10P 32/30, H10P 50/66

(54) **INTERPOSER AND FORMING METHOD THEREFOR**
ZWISCHENSTÜCK UND HERSTELLUNGSVERFAHREN DAFÜR
INTERPOSEUR ET SON PROCÉDÉ DE FORMATION

(30) Priority: 15.06.2023 CN 202310712857
(43) Date of publication of application: 12.02.2025
(73) Proprietor: Hygon Information Technology Co., Ltd., Binhai New Area, Tianjin 300392 (CN)
(72) Inventor: SHENG, Wei, Tianjin 300392 (CN)
(74) Representative: Maiwald GmbH
(86) International application number: PCT/CN2023/121381
(87) International publication number: WO 2024/255015

(56) References cited:
- CN-A- 113 436 972
- CN-A- 113 594 117
- CN-A- 114 078 693
- CN-A- 114 078 693
- CN-A- 116 682 784
- US-A1- 2017 213 798
- US-A1- 2020 126 787
- US-A1- 2021 118 696

## Description

### TECHNICAL FIELD

Embodiments of the present disclosure relate to an interposer and a method of forming the same.

### BACKGROUND

With the development of semiconductor technology, the packaging process has emerged in the implementation of a variety of packaging technologies such as 2.5D packaging (CoWoS, RDL, etc.), 3D packaging (TSV), etc. In addition, in order to achieve the multifunctionality of electronic components, it is necessary to integrate chips with different functions, and Chip_on_Wafer (COW) stacking process is widely used. When packaging components, the stacking of chips and wafers can be achieved based on an interposer due to its high fine-pitch wiring capability.

However, the quality of the interposer formed by common method of forming an interposer is not high. D1 (US20170213798A1) has disclosed a forming large chips through stitching, D2 (US20210118696A1) has disclosed an interposer and a method of manufacturing the interposer, D3 (CN114078693A) has disclosed a semiconductor structure and forming method thereof, D4 (US20200126787A1) has disclosed an anti-reflective coating by ion implantation for lithography patterning.

### SUMMARY

In view of this case, the embodiment of the present disclosure provides an interposer and a method of forming the interposer, which improve the device quality of the interposer.

In order to solve the above problems, an embodiment of the present disclosure provides a method of forming an interposer, which comprises:
providing a baseplate;
forming a pattern transfer layer on the baseplate, wherein the pattern transfer layer comprises a plurality of pattern regions spliced together, different pattern regions correspond to different lithographic templates, a splicing region of at least two pattern regions is an overlapping region, and any one of the lithographic templates comprises a pattern composed of an exposed region for exposure and a masked region for masking;
preprocessing the pattern transfer layer so that the plurality of pattern regions of the pattern transfer layer have different etching selectivity ratios in corresponding exposed regions and masked regions based on patterns of corresponding lithographic templates;
etching the pattern transfer layer after preprocessed to form the patterns of corresponding lithographic templates on the pattern transfer layer; and
patterning the baseplate using the pattern transfer layer as a mask, wherein the plurality of pattern regions includes a first pattern region and a second pattern region partially overlapped with each other, and preprocessing the pattern transfer layer includes: forming a first patterned lithographic mask layer on the pattern transfer layer, and performing a first preprocessing operation on the first pattern region of the pattern transfer layer using the first patterned lithographic mask layer as a mask; removing the first patterned lithographic mask layer; forming a second patterned lithographic mask layer on the pattern transfer layer, and performing a second preprocessing operation on the second pattern region of the pattern transfer layer using the second patterned lithographic mask layer as a mask; and removing the second patterned lithographic mask layer.

In an embodiment, a total number of times of preprocessing of the pattern transfer layer corresponds to a total number of the pattern regions of the pattern transfer layer;

wherein patterns of the first lithographic mask layer and the second lithographic mask layer correspond to patterns of lithographic templates corresponding to the first pattern region and the second pattern region, respectively.

In an embodiment, the preprocessing comprises: implanting ions into an exposed region of the pattern transfer layer using an ion implantation process.

In an embodiment, an ion implantation dose of the ions is E14 to E15 in response to a thickness of the pattern transfer layer being 30 nm.

In an embodiment,
a material of the pattern transfer layer is amorphous silicon; forming the pattern transfer layer on the baseplate comprises: depositing an amorphous silicon layer on the baseplate, and using the amorphous silicon layer as the pattern transfer layer; and
the ion implantation process comprises implanting boron ions into the amorphous silicon layer exposed.

In an embodiment, etching the pattern transfer layer after preprocessed comprises:
removing, using a wet etching process, a transfer layer material of the pattern transfer layer corresponding to the masked region of the lithographic template.

In an embodiment, an etching solution corresponding to the wet etching process comprises a tetramethylammonium hydroxide solution.

In an embodiment, providing a the baseplate comprises:
providing a substrate; and
forming a hard mask material layer on the substrate.

In an embodiment, forming a pattern transfer layer on the baseplate comprises: forming the pattern transfer layer on the hard mask material layer; and
patterning the baseplate using the pattern transfer layer as a mask comprises: patterning the hard mask material layer using the pattern transfer layer as a mask to form a hard mask layer.

In an embodiment, after forming the hard mask layer, the method further comprises:
depositing a conductive material on the hard mask layer to form a conductive interconnect layer;
planarizing the conductive interconnect layer to form a conductive interconnection structure.

The embodiment of the present disclosure also provides an interposer, being prepared and obtained according to the method of forming the interposer according to the above embodiments, the interposer comprises:
a baseplate; and
a conductive interconnection structure, provided on the baseplate, wherein the conductive interconnection structure comprises a plurality of pattern regions spliced together, and a splicing region of at least two pattern regions is an overlapping region.

In an embodiment, conductive interconnection structure patterns corresponding to different pattern regions of the conductive interconnection structure are formed based on different lithographic templates, and any one of the lithographic templates comprises a pattern composed of an exposed region for exposure and a masked region for masking.

In embodiments of the present disclosure provide the method of forming the interposer, by forming a pattern transfer layer including a plurality of pattern regions spliced together on the baseplate, different pattern regions correspond to different lithographic templates, a splicing region of at least two pattern regions is an overlapping region, and any one of the lithographic templates includes a pattern composed of an exposed region for exposure and a masked region for masking; preprocessing the pattern transfer layer so that the plurality of pattern regions of the pattern transfer layer have different etching selectivity ratios in corresponding exposed regions and masked regions based on patterns of corresponding lithographic templates; etching the pattern transfer layer after preprocessed to form the patterns of corresponding lithographic templates on the pattern transfer layer; and patterning the baseplate using the pattern transfer layer as a mask.

By preprocessing the pattern transfer layer on the baseplate, the plurality of pattern regions of the pattern transfer layer have different etching selectivity ratios in corresponding exposed regions and masked regions based on patterns of corresponding lithographic templates; thus pattern transfer can be achieved based on the etching process, ensuring the stability of the patterns on the pattern transfer layer and avoiding pattern deformation. In addition, the pattern transfer layer is used as a mask to pattern the baseplate and form a pattern of an integrated circuit on the baseplate, thereby improving the accuracy of the pattern of the integrated circuit, thereby improving the accuracy of key dimensions and improving the device quality of the interposer.

### BRIEF DESCRIPTION OF DRAWINGS

In order to more clearly illustrate the embodiments of the present disclosure, the drawings that need to be used in the embodiments will be briefly described in the following. Apparently, the drawings in the following description are only some embodiments of the present disclosure. For those ordinarily skilled in the art, other drawings can also be obtained based on these drawings without any inventive work.
FIG. 1 is a diagram of an integrated circuit made up of two masks;
FIG. 2 is a schematic diagram of Mask-1;
FIG. 3 is a schematic diagram of Mask-2;
FIG. 4 to FIG. 6 are schematic diagrams of structures corresponding to steps in a method of forming an interposer;
FIG. 7 is a top view of the change in state of a connection hole pattern after two exposures; and
FIG. 8 to FIG. 26 are schematic diagrams of structures corresponding to steps in an embodiment of a method of forming an interposer provided by the embodiments of the present disclosure.

### DETAILED DESCRIPTION

The technical solutions in the embodiments of the present disclosure will be described in a clearly and fully understandable way in conjunction with the drawings.

The quality of an interposer formed by a common method of forming an interposer is not high. Now, the reasons for the low quality of the interposer will be analyzed based on the method of forming the interposer.

It should be noted that steps such as exposing a mask enable the design pattern of an integrated circuit can be transformed to an interposer, but because the dimension of the mask is fixed, for example, 26mm*33mm, and the interposer of a chip for integrating different functions has a large area, it is necessary to utilize a plurality of masks for exposure splicing to photolithograph the pattern of the integrated circuit to an interposer with a larger area; in addition, in order to ensure the accuracy and completeness of the pattern of the integrated circuit transformed on the interposer, a splicing region corresponding to patterns of a plurality of masks on the interposer is a stitching zone (ST) of the masks.

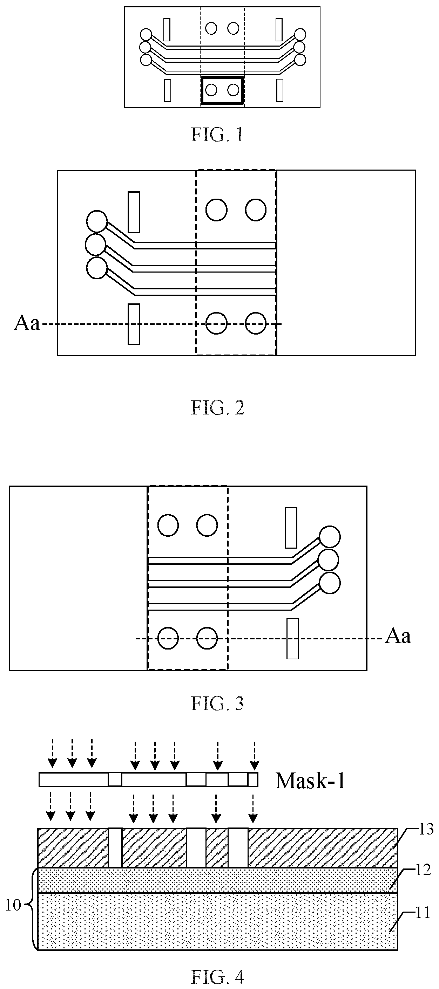

FIG. 1 exemplarily illustrates a diagram of an integrated circuit made up of two masks, and the two masks may be Mask-1 and Mask-2. Referring to FIG. 1, a region enclosed by dotted lines is a stitching zone of the two masks. Moreover, in order to realize the conductive interconnection of the chip, connection holes of different device structures need to be set. In an optional example, connection hole patterns of the device structures can be correspondingly set in the stitching zone of different masks. The connection holes may be patterns composed of exposed regions after the mask is exposed, or patterns composed of masked regions after the mask is exposed, may be set according to actual needs. For example, in FIG. 1, the circular patterns in the stitching zone correspond to the patterns of the connection holes, and the circular patterns are patterns composed of the masked regions exposed by the mask.

Corresponding to FIG. 1, FIG. 2 is a schematic diagram of a mask Mask-1, and FIG. 3 is a schematic diagram of another mask Mask-2, where the line Aa is a cross-section tangent line of the mask. Based on the cross-section along line Aa, FIG. 4 to FIG. 6 illustrate schematic diagrams of structures corresponding to steps in a method of forming an interposer.

Corresponding to FIG. 2, referring to FIG. 4, exposure and development of Mask-1 is performed on a baseplate 10, where the dashed arrows indicate the direction of light.

The baseplate 10 is used for arranging electronic components and other constituent elements, and in an optional example, the baseplate 10 may include a substrate 11 and a hard mask material layer 12 on the substrate. Before the mask is exposed, the baseplate 10 needs to be coated with photoresist, and the photoresist is used as a lithographic mask layer 13 to transform the pattern of Mask-1 onto the lithographic mask layer 13. Photoresist is a photosensitive material, and after exposure, a chemical reaction will occur, resulting in changes in its own properties and structure. For example, the exposed portion may change from a soluble substance to an insoluble substance, and then during the etching step, the unexposed portion is removed to realize the transfer of the mask pattern.

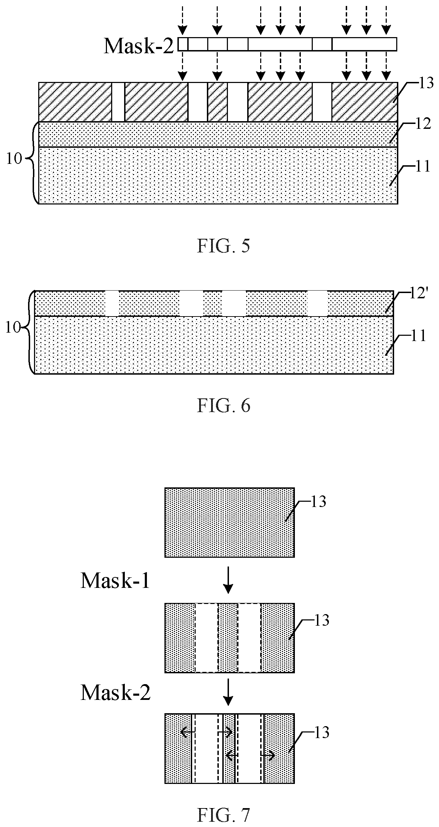

Corresponding to FIG. 3, referring to FIG. 5, exposure and development of Mask-2 is performed on the baseplate 10, and the pattern of Mask-2 is transformed onto the lithographic mask layer 13, where the dashed arrows indicate the direction of light.

Referring to FIG. 6, the baseplate 10 is patterned with the lithographic mask layer 13 after two exposures and development as a mask.

In a specific example, the hard mask material layer exposed by the lithographic mask layer 13 can be etched away through an etching process, using the lithographic mask layer 13 as a mask, to form a hard mask layer 12', thereby transferring the patterns of Mask-1 and Mask-2 to the hard mask layer 12', and then performing subsequent preparation based on the hard mask layer, such as metal deposition and planarization processes to form a conductive connection structure to complete the production of the interposer.

Because there is a stitching zone between Mask-1 and Mask-2, when Mask-1 and Mask-2 are exposed on the baseplate 10, the stitching zone will undergo two exposures. Corresponding to the connection hole patterns in a region enclosed by thick lines in the mask stitching zone in FIG. 1, FIG. 7 exemplarily illustrates a top view of the change in state of the connection hole patterns after two exposures. As illustrated in FIG. 7, when not exposed, the lithographic mask layer 13 does not undergo any changes; after the mask (Mask-1) is first exposed, the connection hole patterns (illustrated as a dotted line in the figure) can be accurately presented; and after the mask (Mask-2) is second exposed, the connection hole patterns change significantly, and compared with the patterns after the first exposure, the connection hole patterns are stretched (in the direction indicated by the arrows in the figure). Therefore, in the subsequent steps of forming the conductive interconnection structure, the deformed connection hole patterns will cause the key dimensions of the connection holes to be distorted, reducing the quality of the interposer device, thereby affecting device performance.

The reason for the reduced quality of the interposer device in the above-mentioned processes is that: the material of the lithographic mask layer 13 is photoresist, and the photoresist has a soft texture, and a chemical reaction occurs after exposure, which causes the photoresist to shrink severely after multiple exposures, thereby causes the first-exposed patterns to be deformed, e.g., the dimension of the connection hole pattern in FIG. 7 becomes larger based on the shrinkage of the photoresist. In addition, because the shrinkage of the photoresist is based on its own changes during exposure, the shrinkage is uncontrollable, which also causes the changes in the connection hole pattern uncontrollable; for example, the connection hole pattern is deformed from a circle to a square after multiple exposures, which leads to a serious distortion of the key dimensions in the subsequent preparation processes, thereby reducing the quality of the interposer device and affecting the device performance.

In addition, after multiple exposures, the photoresist will be scorched and hardened, making it difficult to remove the photoresist and leaving residues, which will lead to a reduction in product yield.

Therefore, it is particularly necessary to provide a method of forming an interposer to avoid pattern deformation when using a plurality masks, to improve the accuracy of integrated circuit pattern, and thus to improve the accuracy of key dimensions and to enhance device quality of the interposer.

The embodiments of the present disclosure provide an improved formation solution of an interposer. By performing a preprocessing operation on a pattern transfer layer on a baseplate, a plurality of pattern regions of the pattern transfer layer have different etching selectivity ratios in corresponding exposed regions and masked regions based on patterns of corresponding lithographic templates, thereby achieving pattern transfer based on the etching process to ensure the stability of the patterns on the pattern transfer layer and avoid pattern deformation. In addition, the pattern transfer layer is used as a mask to pattern the baseplate and form an integrated circuit pattern on the baseplate, improving the accuracy of the integrated circuit pattern, thereby improving the accuracy of key dimensions, and improving the device quality of the interposer.

In order to make the above-mentioned purposes, features and advantages of the embodiments of the present disclosure more obvious and understandable, the specific embodiments of the present disclosure are described in detail below in conjunction with the drawings.

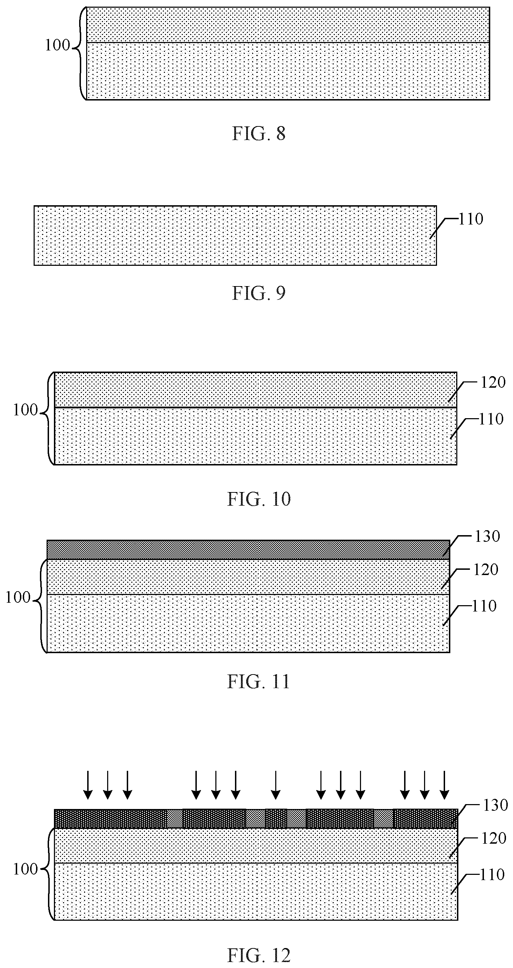

FIG. 8 to FIG. 26 are schematic diagrams of structures corresponding to steps in an embodiment of a method of forming an interposer provided by the embodiments of the present disclosure.

Referring to FIG. 8, a baseplate 100 is provided.

The baseplate 100 is configured to arrange electronic components and other constituent elements. In an optional example, the baseplate may include a substrate and a hard mask material layer on the substrate. Specifically, the step of providing the baseplate 100 may include:
referring to FIG. 9, a substrate 110 is provided.

The substrate 110 is configured to provide a process base for forming the device layer structure, and the material of the substrate 110 may be silicon. In other embodiments, the material of the substrate 110 may be, for example, one or more of silicon, germanium, silicon carbide, gallium arsenide, or indium galliumide; alternatively, the substrate may also be a silicon substrate on an insulator or a germanium substrate on an insulator. Semiconductor devices, such as one or more of PMOS transistors, CMOS transistors, NMOS transistors, resistors, capacitors or inductors, may also be formed in the substrate 110.

Referring to FIG. 10, a hard mask material layer 120 is formed on the substrate 110.

The hard mask material layer 120 is configured to isolate and protect the surface of the substrate 110, and the material of the hard mask material layer may be, for example, one or more of silicon nitride, silicon oxide, or silicon nitride oxide. In a specific embodiment, in the case where the hard mask material layer includes a plurality, the hard mask material layer may be a stack of a plurality of materials, e.g., a stack of a silicon nitride layer and a silicon oxide layer, and the process of forming the hard mask material layer on the substrate may include forming a first hard mask material layer on the substrate first, and then forming a second hard mask material layer on the first hard mask material layer; and in a specific example, the material of the first hard mask layer may be silicon nitride and the material of the second hard mask layer may be silicon oxide.

It should be noted that the above-mentioned example is only an optional example, and the layer structure of the baseplate may be set according to the actual needs, and the embodiments of the present disclosure do not set any limitations thereon.

Referring to FIG. 11, a pattern transfer layer 130 is formed on the baseplate 100.

The pattern transfer layer 130 can be used as a transition layer for forming a complete integrated circuit pattern on the baseplate, which may also be referred to as a transition interposer. The material of the pattern transfer layer may be a material chosen based on a chemical operation or a physical operation capable of changing its corresponding etch selectivity ratio, and in a specific example, the material of the pattern transfer layer may be amorphous silicon.

Because the interposer needs to be masked several times during the formation process, the pattern transfer layer includes a plurality of pattern regions spliced together, different pattern regions correspond to different lithographic templates, and a splicing region of at least two pattern regions is an overlapping region (a stitching zone). For example, the plurality of pattern regions include a first pattern region and a second pattern region that are partially overlapped with each other.

The lithographic template is understood to be a mask, the lithographic template includes a pattern correspondingly, and different lithographic templates can be combined to form a pattern of an integrated circuit. In a process of forming a lithographic pattern based on the lithographic templates, any of the lithographic templates may include a pattern composed of an exposed region for exposure and a masked region for masking. In a specific example, the pattern of the exposed region for exposure of the lithographic template may be a conductive connection line, such as a metal line, corresponding to the formation of a conductive connection structure; and the pattern of the masked region for masking of the lithographic template may be a conductive connection hole, such as a via hole, corresponding to the formation of a conductive connection structure.

As an optional implementation, in the example where the substrate 110 and the hard mask material layer 120 are retained, the step of forming the pattern transfer layer 130 on the baseplate 100 may be specifically as follows: forming the pattern transfer layer 130 on the hard mask material layer 120.

Referring to FIG. 12, the pattern transfer layer 130 is preprocessed.

Based on the pattern transition function of the pattern transfer layer 130, by preprocessing the pattern transfer layer 130, the plurality of pattern regions of the pattern transfer layer can be made to have different etching selectivity ratios in the corresponding exposed regions and masked regions based on patterns of corresponding lithographic templates. For example, as illustrated in FIG. 12, the pattern transfer layer 130 is preprocessed with exposed regions corresponding to darker colored regions of the pattern transfer layer 130, where the etching selectivity ratios of the exposed regions are greater than the etching selectivity ratios of the masked regions.

It should be noted that the pattern of the lithographic template may be transferred to the pattern transfer layer based on a lithographic and etching process. Specifically, a patterned lithographic mask layer is first formed on the pattern transfer layer, the pattern of the lithographic mask layer corresponds to a pattern of a lithographic template corresponding to a pattern region, then the patterns of the exposed regions of the lithographic template expose the material of the pattern transfer layer, and the patterns of the masked regions of the lithographic template mask the material of the pattern transfer layer; and thereafter, a preprocessing operation is performed on the pattern transfer layer using the lithographic mask layer as a mask; and thereafter, the pattern transfer layer after the preprocessing is etched to form the pattern corresponding to the lithographic template on the pattern transfer layer. Because the plurality of pattern regions of the pattern transfer layer have different etching selectivity ratios in the corresponding exposed regions and masked regions based on patterns of corresponding lithographic templates, the etching process is utilized to etch at different rates in the corresponding exposed regions and masked regions, which in turn, based on the different etching rates, is able to ensure the stability of the patterns of the corresponding lithographic templates formed on the pattern transfer layer and avoid the deformation of the patterns.

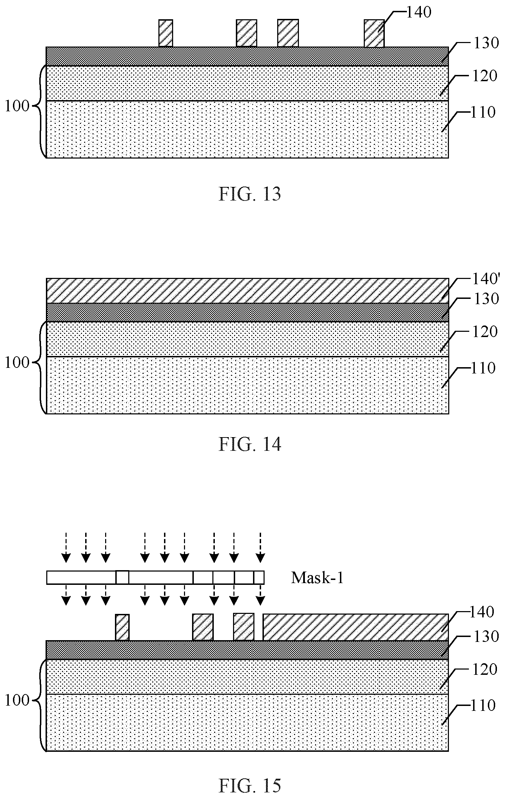

In an optional example, because the pattern transfer layer includes a plurality of pattern regions (e.g., the first pattern region and the second pattern region) spliced together, and different pattern regions corresponding to different lithographic templates, the number of preprocessing times of the pattern transfer layer 130 may be a number corresponding to the number of pattern regions of the pattern transfer layer, so as to transform the patterns of different lithographic templates to the pattern transfer layer 130 to form a complete pattern corresponding to the integrated circuit pattern. In a specific example, for any one of the pattern regions, the step of preprocessing the pattern transfer layer includes:
referring to FIG. 13, a patterned lithography mask layer 140 is formed on the pattern transfer layer 130, and the pattern of the lithography mask layer 140 corresponds to the pattern of the lithography template corresponding to the pattern region.

Specifically, forming the patterned lithographic mask layer 140 on the pattern transfer layer 130 may be performed based on an exposure and development process. Taking Mask-1 as an example, based on the cross-section along line Aa, referring to FIG. 14 and FIG. 15, the process of forming the lithographic mask layer 140 may include:
forming a lithographic mask material layer 140' on the pattern transfer layer 130, in which the lithographic mask material layer 140' may be a photoresist layer; exposing and developing Mask-1, removing the lithographic mask material layer 140' in the exposed regions, and forming the patterned lithographic mask layer 140 on the pattern transfer layer 130; and corresponding to the pattern of the lithographic template, the lithographic mask layer 140 may expose a part of the pattern transfer layer 130, and masking a part of the pattern transfer layer 130.

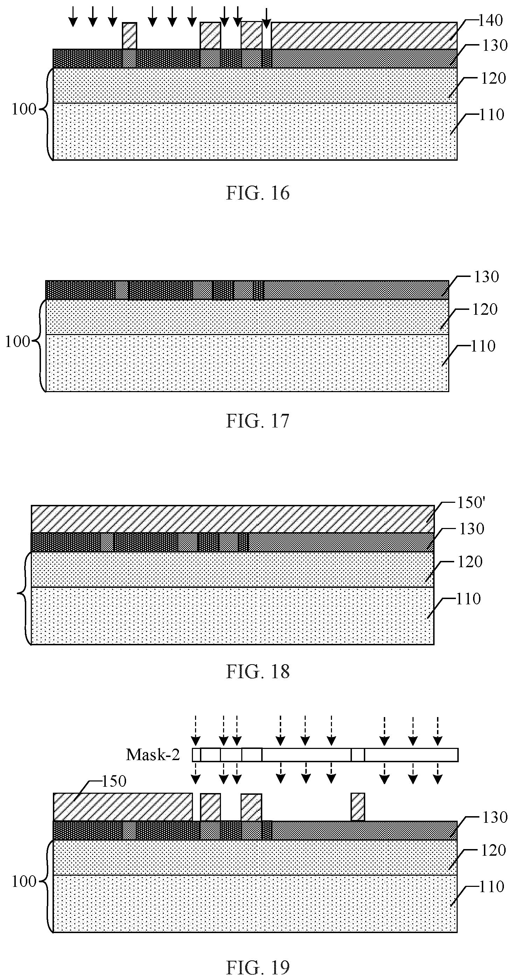

Next, referring to FIG. 16, a single preprocessing operation (or referred to as a first preprocessing operation) is performed on the first pattern region of the pattern transfer layer 130 using the lithographic mask layer 140 (or referred to as a first patterned lithographic mask layer) as a mask.

In an optional example, the preprocessing operation may at least include implanting ions into the exposed regions of the pattern transfer layer 130 using an ion implantation process. Implanting ions into the exposed regions of the pattern transfer layer 130 is capable of enabling the exposed regions and the masked regions of the pattern transfer layer 130 to have different etching selectivity ratios.

The ion implantation dose of the ions may correspond to the thickness of the pattern transfer layer 130 to enable the ions to penetrate the pattern transfer layer 130, thereby maintaining the material stability of the pattern transfer layer 130. In a specific example, if the thickness of the pattern transfer layer is 30 nm, the ion implantation dose of the ions is E14 to E15, where E denotes the ion energy, and the unit of the ion energy is kev; "E14" denotes that the implantation dose of ions is 10 to the 14th power/cm²; and "E15" denotes that the implantation dose of ions is 10 to the 15th power/cm².

It should be noted that the above-mentioned example is only an optional implementation, the pattern transfer layer in the embodiments of the present disclosure may also be of other thicknesses, and accordingly, the ion implantation dose may also change corresponding to the thickness of the pattern transfer layer. The ion implantation dose in the embodiments of the present disclosure corresponds to the thickness of the pattern transfer layer to achieve penetration of the pattern transfer layer, the thickness of the pattern transfer layer and the corresponding ion implantation dose may be correspondingly set according to actual needs, and the embodiments based on the idea of the present disclosure fall within the scope of protection of the embodiments of the present disclosure.

Further in an optional example, the material of the pattern transfer layer may be amorphous silicon, the step of forming the pattern transfer layer on the baseplate may be specified as depositing an amorphous silicon layer on the baseplate with the amorphous silicon layer as the pattern transfer layer; and based on the material nature of the amorphous silicon, the ion implantation process may be specified as implanting boron ions into the amorphous silicon layer exposed to change the etching selectivity ratio of the amorphous silicon layer.

It should be noted that the above-mentioned example is only an optional implementation, the pattern transfer layer in the embodiments of the present disclosure may also be made of other materials, and the way to change the etching selectivity ratio of the pattern transfer layer may be an ion implantation process, a chemical action, or a physical action, and so on, and the embodiments of the present disclosure do not limit this, and may be set according to actual needs, and the embodiments based on the conception of the method of forming the interposer of the present disclosure fall within the scope of protection of the embodiments of the present disclosure.

As an optional implementation, referring to FIG. 17, in the example of retaining the lithographic mask layer 140, for any one of the pattern regions, preprocessing the pattern transfer layer further includes removing the lithographic mask layer 140.

It should be noted that the number of preprocessing times of the pattern transfer layer in the present disclosure corresponds to the number of pattern regions of the pattern transfer layer, and for any one of the pattern regions, after removing the lithographic mask layer 140, it is necessary to form a lithographic mask material layer again on the pattern transfer layer 130 when an operation is performed on the next pattern region. Corresponding to FIG. 14 to FIG. 17, referring to FIG. 18 to FIG. 21, taking Mask-2 as an example, a lithographic mask material layer 150' is formed on the pattern transfer layer 130 based on the cross-section along line Aa; the lithographic mask material layer may be a photoresist layer, and an exposure and development process is performed on Mask-2 to remove the lithographic mask material layer in the exposed regions to form a patterned lithographic mask layer 150 (or referred to as a second patterned lithographic mask layer); and then, a preprocessing operation (or referred to as a second preprocessing operation) is performed on the second pattern region of the pattern transfer layer 130 using the lithographic mask layer 150 as a mask, that is, an ion implantation process is used to implant ions into the exposed regions of the pattern transfer layer 130, so that the exposed regions and the masked regions of the pattern transfer layer 130 have different etching selectivity ratios, and the lithographic mask layer 150 is removed.

It should be understood that the preprocessing of the pattern transfer layer in the embodiments of the present disclosure for any one of the pattern regions includes removing the lithographic mask layer, whereby the lithographic mask layer is able to receive only one exposure, and thus there will be no problem of residual photoresist that is difficult to remove due to multiple exposures to the photoresist, thereby further improving the product yield.

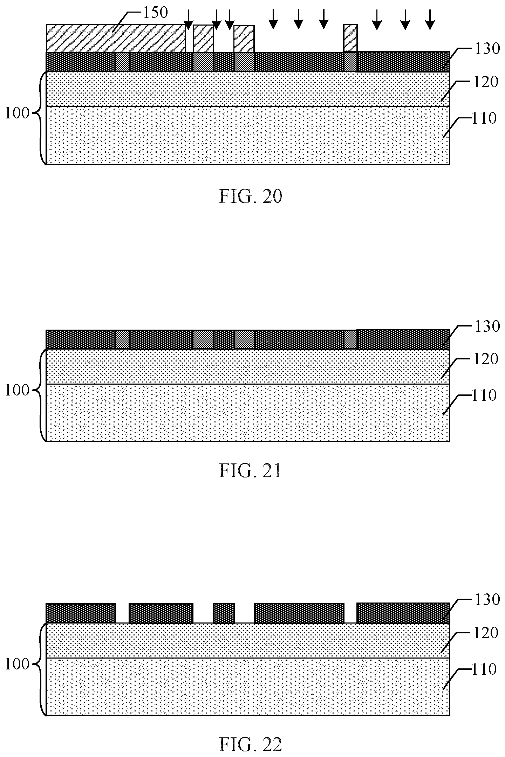

Referring to FIG. 22, the pattern transfer layer 130 after preprocessed is etched to form patterns corresponding to the lithographic template on the pattern transfer layer 130.

In an optional example, etching the pattern transfer layer 130 after preprocessed may be specifically include using a wet etching process to remove the transfer layer material corresponding to the masked regions of the pattern transfer layer 130 corresponding to the lithographic template. Optionally, the material of the pattern transfer layer is amorphous silicon, the ion implantation process includes implanting boron ions into the amorphous silicon layer exposed, the corresponding etching solution in the wet etching process may include a tetramethylammonium hydroxide solution to remove the portion of the amorphous silicon layer that is free of boron ions implantation and to retain the region with boron ions implantation, so as to form an accurate and complete integrated circuit pattern on the amorphous silicon layer.

It should be noted that the above-mentioned example is only an optional implementation, the etching process in the embodiments of the present disclosure may be a wet etching process, a dry etching process, or a process combining wet etching and dry etching, and the etching solution in the wet etching process may also be selected from other solutions according to the preprocessing operation of the pattern transfer layer. The embodiments of the present disclosure do not limit this, and may be set according to actual needs.

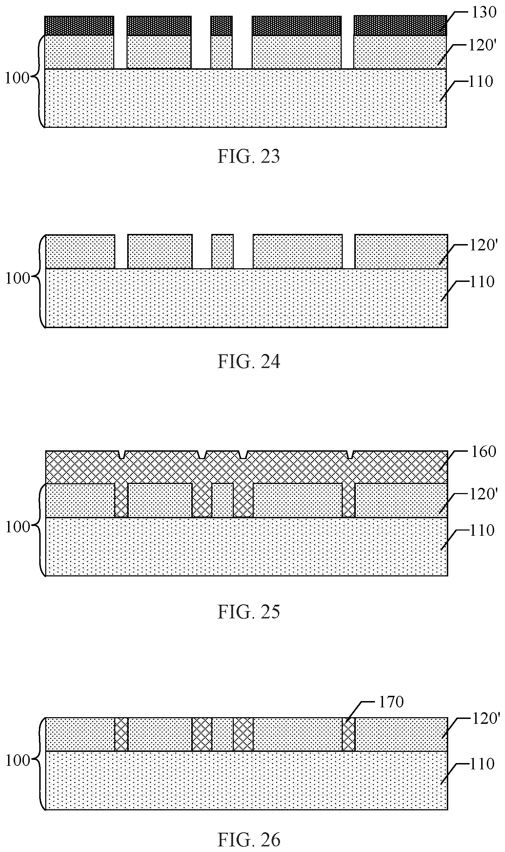

Referring to FIG. 23, the baseplate 100 is patterned using the pattern transfer layer 130 as a mask.

Based on a plurality of pattern regions of the pattern transfer layer, patterns corresponding to different lithographic templates are formed on the pattern transfer layer, so that an accurate pattern corresponding to an integrated circuit can be formed on the pattern transfer layer, and then the baseplate is patterned using the pattern transfer layer as a mask to transfer the accurate pattern to the next layer structure of the pattern transfer layer corresponding to the pattern, and to prepare a conductive connection structure corresponding to the designed integrated circuit and obtain the interposer.

In the embodiments of the present disclosure, by performing a preprocessing operation on the pattern transfer layer on the baseplate, the plurality of pattern regions of the pattern transfer layer have different etching selectivity ratios in corresponding exposed regions and masked regions based on patterns of corresponding lithographic templates, thereby achieving pattern transfer based on the etching process to ensure the stability of the patterns on the pattern transfer layer and avoid pattern deformation. In addition, the pattern transfer layer is used as a mask to pattern the baseplate and form an integrated circuit pattern on the baseplate, improving the accuracy of the integrated circuit pattern, thereby improving the accuracy of key dimensions, and improving the device quality of the interposer.

In some embodiments, in the example of retaining the hard mask material layer 120, the step of patterning the baseplate using the pattern transfer layer as a mask may be specified as patterning the hard mask material layer 120 to form a hard mask layer 120' using the pattern transfer layer 130 as a mask.

In an optional example, after forming the hard mask layer 120', referring to FIG. 24, the pattern transfer layer 130 may be further removed.

Referring to FIG. 25, a conductive material is deposited on the hard mask layer 120' to form a conductive interconnect layer 160.

Referring to FIG. 26, the conductive interconnect layer 160 is planarized to form a conductive interconnection structure 170.

The planarization process of the conductive interconnect layer may be, for example, a chemical-mechanical grinding process. By planarizing the conductive interconnection layer, the surface of the conductive interconnection layer can be made smooth, thereby ensuring the uniformity of the thickness of the film layer and improving the uniformity of subsequently formed conductive interconnection structure. In an example of retaining the hard mask layer 120', the hard mask layer 120' may be used as a stop layer to achieve planarization of the conductive interconnection layer 160.

Because the accuracy of the pattern formed on the baseplate is improved, a complete pattern can be formed on the baseplate, and then a conductive interconnection layer is formed to obtain a conductive interconnection structure, which avoids distortion of the key dimensions of the prepared conductive interconnection structure and improves the device quality.

In the embodiments of the present disclosure, by performing a preprocessing operation on the pattern transfer layer on the baseplate, the plurality of pattern regions of the pattern transfer layer have different etching selectivity ratios in corresponding exposed regions and masked regions based on patterns of corresponding lithographic templates, thereby achieving pattern transfer based on the etching process to ensure the stability of the patterns on the pattern transfer layer and avoid pattern deformation. In addition, the pattern transfer layer is used as a mask to pattern the baseplate and form an integrated circuit pattern on the baseplate, improving the accuracy of the integrated circuit pattern, thereby improving the accuracy of key dimensions, and improving the device quality of the interposer.

The embodiments of the present disclosure further provide an interposer, the interposer can be formed based on the method described above, as illustrated with reference to FIG. 26, the interposer includes:
a baseplate 100;
and a conductive interconnection structure 170 provided on the baseplate 100, in which the conductive interconnection structure 170 includes a plurality of pattern regions spliced together, and a splicing region of at least two pattern regions is an overlapping region.

The conductive interconnection structure 170 may be a structure formed for electrical connection to a chip and/or wafer based on a designed integrated circuit pattern.

In the interposer in the embodiments of the present disclosure, the accuracy of the pattern of the integrated circuit corresponding to the conductive interconnection structure is improved, thereby improving the accuracy of the key dimensions, and improving the device quality.

In some embodiments, the integrated circuit pattern on the interposer may be formed based on steps such as masking, exposure, and the like, so that, in the case where the conductive interconnection structure includes a plurality of pattern regions spliced together, the conductive interconnection structure patterns corresponding to the different pattern regions of the conductive interconnection structure 170 may be formed based on different lithographic templates, and any one of the lithographic templates may include a pattern composed of exposed regions for exposure and masked regions for masking. The lithographic template may be understood to be a mask, and different lithographic templates may be combined to form the integrated circuit pattern.

## Claims

1. A method of forming an interposer, **characterized by** comprising:
providing a baseplate (10; 100);
forming a pattern transfer layer (130) on the baseplate (10; 100), wherein the pattern transfer layer (130) comprises a plurality of pattern regions spliced together, different pattern regions correspond to different lithographic templates, a splicing region of at least two pattern regions is an overlapping region, and any one of the lithographic templates comprises a pattern composed of an exposed region for exposure and a masked region for masking;
preprocessing the pattern transfer layer (130) so that the plurality of pattern regions of the pattern transfer layer (130) have different etching selectivity ratios in corresponding exposed regions and masked regions based on patterns of corresponding lithographic templates;
etching the pattern transfer layer (130) after preprocessed to form the patterns of corresponding lithographic templates on the pattern transfer layer (130); and
patterning the baseplate (10; 100) using the pattern transfer layer (130) as a mask,
wherein the plurality of pattern regions comprises a first pattern region and a second pattern region partially overlapped with each other, and preprocessing the pattern transfer layer (130) comprises:
forming a first patterned lithographic mask layer (140) on the pattern transfer layer (130), and performing a first preprocessing operation on the first pattern region of the pattern transfer layer (130) using the first patterned lithographic mask layer (140) as a mask;
removing the first patterned lithographic mask layer (140);
forming a second patterned lithographic mask layer (150) on the pattern transfer layer (130), and performing a second preprocessing operation on the second pattern region of the pattern transfer layer (130) using the second patterned lithographic mask layer (150) as a mask; and
removing the second patterned lithographic mask layer (150).

2. The method of forming the interposer according to claim 1, wherein a total number of times of preprocessing of the pattern transfer layer (130) corresponds to a total number of the pattern regions of the pattern transfer layer (130);
wherein patterns of the first lithographic mask layer (140) and the second lithographic mask layer (150) correspond to patterns of lithographic templates corresponding to the first pattern region and the second pattern region, respectively.

3. The method of forming the interposer according to claim 2, wherein the preprocessing comprises: implanting ions into an exposed region of the pattern transfer layer (130) using an ion implantation process.

4. The method of forming the interposer according to claim 3, wherein an ion implantation dose of the ions is E14 to E15 in response to a thickness of the pattern transfer layer (130) being 30 nm.

5. The method of forming the interposer according to claim 4, wherein a material of the pattern transfer layer (130) is amorphous silicon;
forming the pattern transfer layer (130) on the baseplate (10; 100) comprises: depositing an amorphous silicon layer on the baseplate (10; 100), and using the amorphous silicon layer as the pattern transfer layer (130); and
the ion implantation process comprises implanting boron ions into the amorphous silicon layer exposed.

6. The method of forming the interposer according to any one of claims 1-5, wherein etching the pattern transfer layer (130) after preprocessed comprises:
removing, using a wet etching process, a transfer layer material of the pattern transfer layer (130) corresponding to the masked region of the lithographic template.

7. The method of forming the interposer according to claim 6, wherein an etching solution corresponding to the wet etching process comprises a tetramethylammonium hydroxide solution.

8. The method of forming the interposer according to any one of claims 1-7, wherein providing the baseplate (10; 100) comprises:
providing a substrate (11; 110); and
forming a hard mask material layer (12; 120) on the substrate (11; 110).

9. The method of forming the interposer according to claim 8, wherein forming the pattern transfer layer (130) on the baseplate (10; 100) comprises: forming the pattern transfer layer (130) on the hard mask material layer (12; 120); and
patterning the baseplate (10; 100) using the pattern transfer layer (130) as a mask comprises: patterning the hard mask material layer (12; 120) using the pattern transfer layer (130) as a mask to form a hard mask layer (12'; 120').

10. The method of forming the interposer according to claim 9, further comprising:
depositing a conductive material on the hard mask layer (12'; 120') to form a conductive interconnect layer (160);
planarizing the conductive interconnect layer (160) to form a conductive interconnection structure (170).

11. An interposer, **characterized by** being prepared and obtained according to the method of forming the interposer according to any one of claims 1 to 10, wherein the interposer comprises:
a baseplate (10; 100); and
a conductive interconnection structure (170), provided on the baseplate (10; 100), wherein the conductive interconnection structure (170) comprises a plurality of pattern regions spliced together, and a splicing region of at least two pattern regions is an overlapping region.

12. The interposer according to claim 11, wherein conductive interconnection structure patterns corresponding to different pattern regions of the conductive interconnection structure (170) are formed based on different lithographic templates, and any one of the lithographic templates comprises a pattern composed of an exposed region for exposure and a masked region for masking.

## Patentansprüche

1. Verfahren zur Herstellung eines Interposers, **dadurch gekennzeichnet, dass** dieses umfasst:
Bereitstellen einer Grundplatte (10; 100);
Bilden einer Musterübertragungsschicht (130) auf der Grundplatte (10; 100), wobei die Musterübertragungsschicht (130) eine Vielzahl von miteinander verbundenen Musterbereichen umfasst, verschiedene Musterbereiche unterschiedlichen lithografischen Schablonen entsprechen, ein Verbindungsbereich von mindestens zwei Musterbereichen ein überlappender Bereich ist und jede der lithografischen Schablonen ein Muster umfasst, das aus einem belichteten Bereich zur Belichtung und einem maskierten Bereich zur Maskierung besteht;
Vorbehandeln der Musterübertragungsschicht (130), so dass die Vielzahl von Musterbereichen der Musterübertragungsschicht (130) unterschiedliche Ätzselektivitätsverhältnisse in entsprechenden belichteten Bereichen und maskierten Bereichen aufweist, basierend auf Mustern entsprechender lithografischer Schablonen;
Ätzen der Musterübertragungsschicht (130) nach der Vorbehandlung, um die Muster der entsprechenden lithografischen Schablonen auf der Musterübertragungsschicht (130) zu bilden; und
Strukturieren der Grundplatte (10; 100) unter Verwendung der Musterübertragungsschicht (130) als Maske,
wobei die Vielzahl von Musterbereichen einen ersten Musterbereich und einen zweiten Musterbereich umfasst, die sich teilweise überlappen, und das Vorbehandeln der Musterübertragungsschicht (130) umfasst:
Bilden einer ersten strukturierten lithografischen Maskenschicht (140) auf der Musterübertragungsschicht (130) und Durchführen eines ersten vorbehandelnden Arbeitsgangs (141) auf dem ersten Musterbereich der Musterübertragungsschicht (130) unter Verwendung der ersten strukturierten lithografischen Maskenschicht (140) als Maske;
Entfernen der ersten strukturierten lithografischen Maskenschicht (140);
Bilden einer zweiten strukturierten lithografischen Maskenschicht (150) auf der Musterübertragungsschicht (130) und Durchführen eines zweiten vorbehandelnden Arbeitsgangs an dem zweiten Musterbereich der Musterübertragungsschicht (130) unter Verwendung der zweiten strukturierten lithografischen Maskenschicht (150) als Maske; und
Entfernen der zweiten strukturierten lithografischen Maskenschicht (150).

2. Verfahren zum Herstellen des Interposers nach Anspruch 1, wobei die Gesamtzahl der Vorbehandlungen der Musterübertragungsschicht (130) der Gesamtzahl der Musterbereiche der Musterübertragungsschicht (130) entspricht;
wobei Muster der ersten lithografischen Maskenschicht (140) und der zweiten lithografischen Maskenschicht (150) Mustern von lithografischen Schablonen entsprechen, die jeweils dem ersten Musterbereich bzw. dem zweiten Musterbereich entsprechen.

3. Verfahren zum Herstellen des Interposers nach Anspruch 2, wobei das Vorbehandeln umfasst: Implantieren von Ionen in einen freiliegenden Bereich der Musterübertragungsschicht (130) unter Verwendung eines Ionenimplantationsverfahrens.

4. Verfahren zum Herstellen des Interposers nach Anspruch 3, wobei die Ionenimplantationsdosis der Ionen E14 bis E15 beträgt, entsprechend einer Dicke der Musterübertragungsschicht (130) von 30 nm.

5. Verfahren zum Herstellen des Interposers nach Anspruch 4, wobei das Material der Musterübertragungsschicht (130) aus amorphem Silizium besteht;
Ausbilden der Musterübertragungsschicht (130) auf der Grundplatte (10; 100) umfassend: Aufbringen einer amorphen Siliziumschicht auf die Grundplatte (10; 100) und Verwenden der amorphen Siliziumschicht als Musterübertragungsschicht (130); und
wobei der Ionenimplantationsprozess das Implantieren von Borionen in die freiliegende amorphe Siliziumschicht umfasst.

6. Verfahren zum Herstellen des Interposers gemäß einem der Ansprüche 1 bis 5, wobei das Ätzen der Musterübertragungsschicht (130) nach dem Vorbehandeln umfasst:
Entfernen eines Übertragungsschichtmaterials der Musterübertragungsschicht (130), das dem maskierten Bereich der lithografischen Schablone entspricht, unter Verwendung eines Nassätzverfahrens.

7. Verfahren zum Herstellen des Interposers nach Anspruch 6, wobei eine dem Nassätzverfahren entsprechende Ätzlösung eine Tetramethylammoniumhydroxid-Lösung umfasst.

8. Verfahren zum Herstellen des Interposers nach einem der Ansprüche 1 bis 7, wobei das Bereitstellen der Grundplatte (10; 100) umfasst:
Bereitstellen eines Substrats (11; 110); und
Bilden einer Hartmaskenmaterialschicht (12; 120) auf dem Substrat (11; 110).

9. Verfahren zum Herstellen des Interposers nach Anspruch 8, wobei das Bilden der Musterübertragungsschicht (130) auf der Grundplatte (10; 100) umfasst: Bilden der Musterübertragungsschicht (130) auf der Hartmaskenmaterialschicht (12; 120); und
Strukturieren der Grundplatte (10; 100) unter Verwendung der Musterübertragungsschicht (130) als Maske umfassend: Strukturieren der Hartmaskenmaterialschicht (12; 120) unter Verwendung der Musterübertragungsschicht (130) als Maske, um eine Hartmaskenmaterialschicht (12'; 120') zu bilden.

10. Verfahren zum Herstellen des Interposers nach Anspruch 9, ferner umfassend:
Aufbringen eines leitfähigen Materials auf die Hartmasken-Schicht (12'; 120'), um eine leitfähige Verbindungsschicht (160) zu bilden;
Planarisieren der leitfähigen Verbindungsschicht (160), um eine leitfähige Verbindungsstruktur (170) zu bilden.

11. Ein Interposer, **dadurch gekennzeichnet, dass** er nach dem Verfahren zum Herstellen des Interposers nach einem der Ansprüche 1 bis 10 hergestellt und erhalten wird, wobei der Interposer umfasst:
eine Grundplatte (10; 100); und
eine leitfähige Verbindungsstruktur (170), die auf der Grundplatte (10; 100) vorgesehen ist, wobei die leitfähige Verbindungsstruktur (170) eine Vielzahl von miteinander verbundenen Musterbereichen umfasst und ein Verbindungsbereich von mindestens zwei Musterbereichen ein überlappender Bereich ist.

12. Interposer nach Anspruch 11, wobei Muster der leitfähigen Verbindungsstruktur, die verschiedenen Musterbereichen der leitfähigen Verbindungsstruktur (170) entsprechen, auf der Grundlage verschiedener lithografischer Schablonen gebildet werden und jede der lithografischen Schablonen ein Muster umfasst, das aus einem belichteten Bereich zur Belichtung und einem maskierten Bereich zur Maskierung besteht.

## Revendications

1. Procédé de formation d'un interposeur, **caractérisé en ce qu'**il comprend :
la fourniture d'une plaque de base (10 ; 100) ;
la formation d'une couche de transfert de motifs (130) sur la plaque de base (10 ; 100), dans lequel la couche de transfert de motifs (130) comprend une pluralité de régions de motif épissées ensemble, différentes régions de motif correspondent à différents modèles lithographiques, une région d'épissure d'au moins deux régions de motif est une région de chevauchement, et l'un quelconque des modèles lithographiques comprend un motif composé d'une région exposée pour exposition et d'une région masquée pour masquage ;
le pré-traitement de la couche de transfert de motifs (130) de sorte que la pluralité de régions de motif de la couche de transfert de motifs (130) ont des rapports de sélectivité de gravure différents dans des régions exposées et des régions masquées correspondantes sur la base de motifs de modèles lithographiques correspondants ;
la gravure de la couche de transfert de motifs (130) après pré-traitement pour former les motifs de modèles lithographiques correspondants sur la couche de transfert de motifs (130) ; et
la création de motifs sur la plaque de base (10 ; 100) en utilisant la couche de transfert de motifs (130) comme masque,
dans lequel la pluralité de régions de motif comprend une première région de motif et une seconde région de motif qui se chevauchent partiellement l'une et l'autre, et le pré-traitement de la couche de transfert de motifs (130) comprend :
la formation d'une première couche de masque lithographique à motifs (140) sur la couche de transfert de motifs (130), et la réalisation d'une première opération de pré-traitement sur la première région de motif de la couche de transfert de motifs (130) en utilisant la première couche de masque lithographique à motifs (140) comme masque ;
le retrait de la première couche de masque lithographique à motifs (140) ;
la formation d'une seconde couche de masque lithographique à motifs (150) sur la couche de transfert de motifs (130), et la réalisation d'une seconde opération de pré-traitement sur la seconde région de motif de la couche de transfert de motifs (130) en utilisant la seconde couche de masque lithographique à motifs (150) comme masque ;et
le retrait de la seconde couche de masque lithographique à motifs (150).

2. Procédé de formation de l'interposeur selon la revendication 1, dans lequel un nombre total de pré-traitements de la couche de transfert de motifs (130) correspond à un nombre total des régions de motif de la couche de transfert de motifs (130) ;
dans lequel des motifs de la première couche de masque lithographique (140) et de la seconde couche de masque lithographique (150) correspondent à des motifs de modèles lithographiques correspondant à la première région de motif et à la seconde région de motif, respectivement.

3. Procédé de formation de l'interposeur selon la revendication 2, dans lequel le pré-traitement comprend : l'implantation d'ions dans une région exposée de la couche de transfert de motifs (130) à l'aide d'un processus d'implantation ionique.

4. Procédé de formation de l'interposeur selon la revendication 3, dans lequel une dose d'implantation ionique des ions est de E14 à E15 lorsqu'une épaisseur de la couche de transfert de motifs (130) est de 30 nm.

5. Procédé de formation de l'interposeur selon la revendication 4, dans lequel un matériau de la couche de transfert de motifs (130) est du silicium amorphe ;
la formation de la couche de transfert de motifs (130) sur la plaque de base (10 ; 100) comprend : le dépôt d'une couche de silicium amorphe sur la plaque de base (10 ; 100), et l'utilisation de la couche de silicium amorphe comme couche de transfert de motifs (130) ; et
le processus d'implantation ionique comprend l'implantation d'ions bore dans la couche de silicium amorphe exposée.

6. Procédé de formation de l'interposeur selon l'une des revendications 1 à 5, dans lequel la gravure de la couche de transfert de motifs (130) après l'avoir pré-traitée comprend :
le retrait, à l'aide d'un processus de gravure en voie humide, d'un matériau de couche de transfert de la couche de transfert de motifs (130) correspondant à la région masquée du modèle lithographique.

7. Procédé de formation de l'interposeur selon la revendication 6, dans lequel une solution de gravure correspondant au processus de gravure en voie humide comprend une solution d'hydroxyde de tétraméthylammonium.

8. Procédé de formation de l'interposeur selon l'une des revendications 1 à 7, dans lequel la fourniture de la plaque de base (10 ; 100) comprend :
la fourniture d'un substrat (11 ; 110) ; et
la formation d'une couche de matériau de masque dur (12 ; 120) sur le substrat (11 ; 110).

9. Procédé de formation de l'interposeur selon la revendication 8, dans lequel la formation de la couche de transfert de motifs (130) sur la plaque de base (10 ; 100) comprend : la formation de la couche de transfert de motifs (130) sur la couche de matériau de masque dur (12 ; 120) ; et
la création de motifs sur la plaque de base (10 ; 100) à l'aide de la couche de transfert de motifs (130) en tant que masque comprend : la création de motifs sur la couche de matériau de masque dur (12 ; 120) à l'aide de la couche de transfert de motifs (130) en tant que masque pour former une couche de masque dur (12' ; 120').

10. Procédé de formation de l'interposeur selon la revendication 9, comprenant en outre :
le dépôt d'un matériau conducteur sur la couche de masque dur (12' ; 120') pour former une couche d'interconnexion conductrice (160) ;
la planarisation de la couche d'interconnexion conductrice (160) pour former une structure d'interconnexion conductrice (170).

11. Interposeur, **caractérisé en ce qu'**il est préparé et obtenu selon le procédé de formation de l'interposeur selon l'une des revendications 1 à 10, dans lequel l'interposeur comprend :
une plaque de base (10 ; 100) ; et
une structure d'interconnexion conductrice (170), agencée sur la plaque de base (10 ; 100), dans lequel la structure d'interconnexion conductrice (170) comprend une pluralité de régions de motif épissées ensemble, et une région d'épissure d'au moins deux régions de motif est une région de chevauchement.

12. Interposeur selon la revendication 11, dans lequel des motifs de structure d'interconnexion conductrice correspondant à différentes régions de motif de la structure d'interconnexion conductrice (170) sont formés sur la base de différents modèles lithographiques, et l'un quelconque des modèles lithographiques comprend un motif composé d'une région exposée pour exposition et d'une région masquée pour masquage.
